# EUROPEAN PATENT APPLICATION

(11) **EP 4 468 010 A1**
(43) Date of publication of application: **27.11.2024**
(21) Application number: 23175542.2
(22) Date of filing: 26.05.2023
(51) Int. Cl.: G01R 33/56, G01R 33/565, G06N 3/02

(54) **MACHINE LEARNING BASED GENERATION OF SYNTHETIC CONTRAST-WEIGHTED IMAGES**

(71) Applicant: Koninklijke Philips N.V., 5656 AG Eindhoven (NL)
(72) Inventor: MEINEKE, Jan Jakob, Eindhoven (NL); DONEVA, Mariya Ivanova, Eindhoven (NL)
(74) Representative: Philips Intellectual Property & Standards

(57) **Abstract**

Disclosed herein is a medical system for producing synthetic contrast-weighted images, the medical system comprising: a memory storing machine executable instructions; and a computational system, wherein execution of the machine executable instructions causes the computational system to: provide a trained image generation module, the trained image generation module being configured to generate from an input magnetic resonance image of a volume at least one synthetic contrast-weighted image of the volume, the image generation module being trained by compensating for acquisition artefacts in training input magnetic resonance images and associated training acquired contrast-weighted images; receive a magnetic resonance image of a volume; input the magnetic resonance image into the trained image generation module for obtaining the at least one synthetic contrast-weighted image.

## Description

### FIELD OF THE INVENTION

The invention relates to magnetic resonance imaging, in particular to generation of synthetic contrast-weighted magnetic resonance (MR) images.

### BACKGROUND OF THE INVENTION

Contrast-to-Contrast Mappings based on neural networks may be used to generate additional clinically useful images from information contained in a set of acquired images. This could for example be used to accelerated examinations, by allowing to omit certain scans if the information contained in them can be generated based on already acquired information.

The journal article `Accelerated Synthetic MRI with Deep Learning-Based Reconstruction for Pediatric Neuroimaging' by E. Kim et al. in AJNR 43(2022)1653-59 concerns a deep-leaning method for reconstruction in synthetic MR imaging. The article mentions the problem of motion during the acquisition of the source data and attempts to reduce motion artefacts by reducing the acquisition time.

### SUMMARY OF THE INVENTION

The invention provides for a medical system, a computer program and a method in the independent claims. Embodiments are given in the dependent claims.

Embodiments may add an alignment network between the output of a contrast-generation network and a chosen loss function. The alignment network has access to the estimated contrast and the target image and computes a transformation (rigid-body, affine, or deformable) such that applying the transformation to the estimated contrast image may bring it closer to the target image. A spatially adaptive loss function is presented that alleviates the need for strict voxel-to-voxel correspondences in the supervised training of neural networks for contrast-to-contrast mapping. The method may be based on spatial transformer networks added during training before computation of the loss function.

In one aspect the invention provides for a medical system for producing synthetic contrast-weighted images, the medical system comprising: a memory storing machine executable instructions; and a computational system, wherein execution of the machine executable instructions causes the computational system to: provide a trained image generation module, the image generation module being trained to receive at least one input magnetic resonance image of a volume and output at least one synthetic contrast-weighted image based on a ground truth image representing the synthetic contrast-weighted image. The image generation module is trained by compensating for acquisition artefacts in training input magnetic resonance images and associated training acquired contrast-weighted images. The training input magnetic resonance images may be input magnetic resonance images used for training. The training acquired contrast-weighted images may be acquired contrast-weighted images used for the training. The ground truth image may be the training acquired contrast-weighted image. For example, the trained image generation module may be trained to compensate for a potential motion of the volume between an acquisition of the input image and acquisition of the associated ground truth image. At least one magnetic resonance image of the volume may be received. The at least one magnetic resonance image of the volume may be input to the trained image generation module for obtaining the at least one synthetic contrast-weighted image.

In one example, the received at least one input magnetic resonance image of the volume during training and during inference may be multiple magnetic resonance images of the volume. In one example, the received at least one input magnetic resonance image of the volume during training and during inference may be one magnetic resonance image of the volume.

In one example, the output at least one synthetic contrast-weighted image during training and during inference may be multiple synthetic contrast-weighted images. In one example, the output at least one synthetic contrast-weighted image during training and during inference may be one synthetic contrast-weighted image.

The present method may involve three types of MR images, namely the input magnetic resonance image, the contrast-weighted image which is acquired (real) or predicted (synthetic).

For example, a magnetic resonance imaging sequence may be defined by an imaging protocol. The imaging protocol comprises parameters with respective specific values. In magnetic resonance (MR) imaging, the imaging protocol may be used to acquire magnetic resonance data. The imaging protocol may be selected such that it defines the structure of the magnetic resonance imaging sequence, e.g., the number and arrangement of radio frequency (RF) and magnetic field gradient pulses, readout operations, and so forth.

The imaging protocol may be designed to provide a particular type of contrast, e.g., Tl weighting contrast, T2 weighting contrast, T2* weighting contrast, diffusion weighted contrast, or so forth. The imaging protocol may represent a specific contrast type. For example, T1-weighting and T2-weighting may imply that image contrast is significantly affected by T1 and T2 respectively. The magnetic resonance images that are produced using this imaging protocol may thus be referred to as contrast-weighted images of the specific contrast type. The acquired contrast-weighted image may, for example, be a routine clinical image.

The input magnetic resonance image (used during training or used during inference) may be obtained with an imaging protocol that allows simultaneous measurement of multiple tissue properties in a single acquisition. For example, the input magnetic resonance image may contain all information about how tissue parameters (T1, T2, etc.) affect the MR signal. In one example, the at least one input magnetic resonance image may be obtained by acquiring images at multiple saturation delays and multiple echo times (MDME). Alternatively, the at least one input magnetic resonance image may be obtained by MR Fingerprinting (MRF).

However, the production of the contrast-weighted images may be resource consuming and may not be possible to produce a desired high number of contrast-weighted images. For that, synthetic contrast-weighted images may be produced. The synthetic contrast-weighted images are usually produced to represent the respective real contrast-weighted images. The real contrast-weighted image may be an MR image that is reconstructed from MR data acquired by the magnetic resonance imaging sequence that represents the respective contrast type. The present subject matter may use one or more machine learning models to produce the required quantity of synthetic contrast-weighted images for different contrast types. In addition, the present subject matter may provide the synthetic contrast-weighted images which accurately represent the respective real contrast-weighted images by taking into account (correcting) the acquisition artifacts.

The trained image generation module may, for example, be configured to generate from multiple input magnetic resonance images of a volume one synthetic contrast-weighted image of the volume of a specific contrast type. The volume may, for example, be the brain of a patient or any other tissue that can be imaged using a MRI system. Alternatively, the trained image generation module may, for example, be configured to generate from one input magnetic resonance image of a volume one synthetic contrast-weighted image of the volume of a specific contrast type. Alternatively, the trained image generation module may, for example, be configured to generate from multiple input magnetic resonance images of a volume multiple synthetic contrast-weighted images of the volume, each representing a respective specific contrast type. Alternatively, the trained image generation module may, for example, be configured to generate from one input magnetic resonance image of a volume multiple synthetic contrast-weighted images of the volume, each representing a respective specific contrast type.

The produced synthetic contrast-weighted images may, for example, be used for training other machine learning models for performing tasks related to MR imaging such as denoising of MR images.

The acquisition artefacts may be caused by one or more different sources. For example, the acquisition arterfacts may be caused by the MRI system hardware or by the interaction of the patient with the hardware. The acquisition artefacts may, for example, be Zipper artefacts. According to one embodiment, the acquisition artefacts are misalignments which are caused by a motion of the volume between an acquisition of the input magnetic resonance image and acquisition of the associated real contrast-weighted image. This embodiment may, for example, mitigate through-plane motion artefacts while having a low hallucination level in which the model would introduce morphological changes.

In another embodiment, the contrast type comprises a T1 weighted (T1w) contrast.

In another embodiment, the contrast type comprises a T2 (T2w) weighted contrast.

In another embodiment, the contrast type comprises a fluid-attenuated inversion recovery (FLAIR) contrast.

In another embodiment, the contrast type comprises a double inversion recovery (DIR) contrast.

In another embodiment, the contrast type comprises a T2-star weighted (T2*w) contrast.

In another embodiment, the contrast type comprises a Dixon water contrast.

In another embodiment, the contrast type comprises a Dixon fat contrast.

In another embodiment, the contrast type comprises a Dixon fat fraction contrast.

In another embodiment, the contrast type comprises a diffusion-weighted contrast.

In another embodiment, the contrast type comprises a functional magnetic resonance contrast.

In another embodiment, the contrast type comprises a proton density magnetic resonance contrast.

Using a spin echo sequence, as an example, three contrast types of contrast in MR imaging may be T1w contrast, T2w contrast, as well as proton density contrast.

In the case of Tl, T2, or T2* contrast, the imaging provides contrast for differences in the Tl, T2, or T2* (resp.) relaxation time of the tissue. Protocol parameters such as the time-to-echo (TE), sequence repetition time (TR), excitation flip angle (FA), and so forth may be used to control the strength of Tlw, T2w, or T2w* contrast. In other types of contrast, the imaging protocol may include preparatory or magnetic resonance- manipulative RF pulses and/or magnetic field gradients that are applied to generate the desired contrast. For example, in diffusion weighted imaging, the imaging protocol is designed to provide contrast based on local molecular diffusion characteristics.

According to one embodiment, the medical system further comprises a magnetic resonance imaging system, wherein the memory further contains pulse sequence commands configured to control the magnetic resonance imaging system to acquire k-space data according to a magnetic resonance imaging protocol, wherein execution of the machine executable instructions further causes the computational system to: acquire the k-space data by controlling the magnetic resonance imaging system; reconstruct the magnetic resonance image from the k-space data. This embodiment may be advantageous as it may enable a seamless integration of the present subject matter in existing MRI systems.

The image generation module may, for example, be a first machine learning model. The first machine learning model may, for example, be a neural network.

According to one embodiment, the first machine learning model is a U-net.

According to embodiment, the first machine learning model is a ResNet neural network.

According to embodiment, the first machine learning model is a vision transformer neural network.

According to embodiment, the first machine learning model is an auto-encoder neural network.

According to embodiment, the first machine learning model is a variational auto-encoder neural network.

According to embodiment, the first machine learning model is a convolutional neural network.

Using a neural network may provide accurate synthetic images. Using different types of networks may enable a flexible implementation of the present subject matter and may make use of advantageous features of each type of networks.

According to one embodiment, the medical system comprises the trained image generation module. This may enable a local processing of images e.g., without requiring a network connection. This may save resources such as network resources.

According to one embodiment, the medical system is configured to connect to a remote system comprising the trained image generation module. This embodiment may enable access to the trained image generation module by multiple medical systems. This may enable a centralized control of the production of the contrast-weighted images.

According to one embodiment, the training of the first machine learning model may be performed by using a training dataset. The training dataset comprises acquired contrast-weighted images of a volume and associated one or more acquired magnetic resonance images (e.g., MRF images) of the volume. For example, the training dataset may comprise entries wherein each entry comprises a pair of: (*n* magnetic resonance images of the volume, *m* acquired contrast-weighted images of the volume), where *n*>=1 and *m*>=1, wherein in each iteration a pair is provided as input so that *m* synthetic contrast-weighted images may be produced from the *n* magnetic resonance images of the pair and the *m* acquired contrast-weighted images may be compared against the *m* synthetic contrast-weighted images to estimate the loss function. The *m* acquired contrast-weighted images may be associated with *m* different contrast types.

In addition, a number N of one or more second machine learning models may be provided, where N is an integer higher than or equal to one, N>=1. E.g., the number N may correspond or equal to the number *m* of contrast types. Each second machine learning model of the N second machine learning models is associated with a distinct contrast type. Each second machine learning model of the N second machine learning models is configured to estimate a transformation for correction of an input initial synthetic contrast-weighted image of a specific contrast type. At least one specific acquired magnetic resonance image of the training dataset may be input in step a) to the first machine learning model for obtaining at least one initial synthetic contrast-weighted image representing respectively the at least one acquired contrast-weighted image associated with said at least one specific acquired magnetic resonance image. The at least one initial synthetic contrast-weighted image and the associated acquired contrast-weighted image may be input in step b) to the at least one second machine learning model for estimating a transformation for each initial synthetic contrast-weighted image. The at least one estimated transformation may be applied in step c) to the at least one initial synthetic contrast-weighted image for producing at least one aligned synthetic contrast-weighted image respectively. A loss function may be evaluated in step d) by comparing the transformed synthetic contrast-weighted image with respective acquired contrast-weighted image. The first machine learning model and the at least one second machine learning model may be adapted in step e) in accordance with the evaluated loss function. Steps a) to e) are repeated until the loss function fulfills a convergence criterion.

The loss function may represent a difference between the transformed synthetic contrast-weighted image with the respective acquired contrast-weighted image. The convergence criterion may, for example, require that the loss function exceeds a threshold.

For example, a module e.g., named alignment module, may be provided. The alignment module comprises the N second machine learning models.

This embodiment may provide the second machine learning model as an alignment network between the output of the first machine learning model and the chosen loss function. The alignment network may have access to the estimated contrast and the target image and computes a transformation (rigid-body, affine, or deformable) such that applying the transformation to the estimated contrast image may bring it closer to the target image.

In one example, the learned transformation of the alignment module may be used as part of the quality assessment of the first machine learning model. The alignment module may, for example, be used to transform the synthetic contrast-weighted image to match a conventionally acquired contrast-weighted image (or vice versa), so that after the transformation voxel-wise difference computations may be more meaningful. The voxel-wise mean-squared- or mean-absolute error may be one possibility to assess quality. Visual inspection may also be a possibility that may be easier to perform if remaining small deformations are eliminated before.

According to one embodiment, before executing the method (steps a) to e)) the first machine learning model may be pre-trained with another training dataset comprising acquired contrast-weighted images of a volume and associated one or more acquired magnetic resonance images of the volume. This may enable to skip the training of the second machine learning model until the first machine learning model has sufficiently stabilized. This may facilitate the task of the second machine learning model(s) which may then only have to learn a spatial transform between images of very similar contrast.

According to one embodiment, the at least one synthetic contrast-weighted image is multiple synthetic contrast-weighted images representing different contrast types, wherein the at least one second machine learning model is one machine learning model.

That is, a single second machine learning model may be used to estimate transformations for different contrast types. This may be advantageous as the second machine learning model may flexibly be implemented with different first machine learning models that produce synthetic images of different contrast types.

According to one embodiment, the at least one synthetic contrast-weighted image is multiple synthetic contrast-weighted images representing different contrast types, wherein the at least one second machine learning model comprises one second machine learning model per contrast type. This may enable an accurate generation of the synthetic contrast-weighted images since the transformations are independently and accurately estimated per distinct contrast type.

According to one embodiment, the second machine learning model is a neural network.

In another embodiment, the second machine learning model is a U-net.

In another embodiment, the second machine learning model is a ResNet neural network.

In another embodiment, the second machine learning model is a vision transformer neural network.

In another embodiment, the second machine learning model is an auto-encoder neural network.

In another embodiment, the second machine learning model is a variational auto-encoder neural network.

In another embodiment, the second machine learning model is a convolutional neural network.

According to one embodiment, the training method further comprises weighting the loss function with one or more trainable weights of the second machine learning model. The weights indicate a level of success of the transformation to correct a respective position in the synthetic contrast-weighted image.

The weighting may be learned such that it determines whether the spatial transformation can successfully align the images. This can be useful to reduce the weight of positions where the alignment cannot be improved.

According to one embodiment, the training of the first machine learning model may be performed by using a training dataset. The training dataset comprises entries, wherein each entry comprises one or more acquired contrast-weighted images of a volume and associated one or more acquired magnetic resonance images of the volume. For example, the training dataset may comprise entries wherein each entry comprises a pair of: (*n* magnetic resonance images of the volume, *m* acquired contrast-weighted images of the volume), where *n*>=1 and *m>*=1*,* wherein in each iteration a pair is provided as input so that *m* synthetic contrast-weighted images may be produced from the *n* magnetic resonance images of the pair and the *m* acquired contrast-weighted images may be compared against the *m* synthetic contrast-weighted images to estimate the loss function. The *m* acquired contrast-weighted images may be associated with *m* different contrast types.

In addition, a number N of transformers may be provided, where N is an integer higher than or equal to one, N>=1. E.g., the number N may correspond or equal to the number *m* of contrast types. Each transformer of the N transformers may be associated with a distinct contrast type. Each transformer of the N transformers is configured to estimate a transformation for correction of an input initial synthetic contrast-weighted image of a specific contrast type. At least one specific acquired magnetic resonance image of the training dataset may be input in step a) to the first machine learning model for obtaining at least one initial synthetic contrast-weighted image representing respectively the at least one acquired contrast-weighted image which is associated in the training dataset with said at least specific acquired magnetic resonance image. The at least one initial synthetic contrast-weighted image and the associated acquired contrast-weighted image may be input in step b) to the respective at least one transformer for estimating a transformation for each initial synthetic contrast-weighted image. The at least one estimated transformation may be applied in step c) to the at least one initial synthetic contrast-weighted image for producing at least one aligned synthetic contrast-weighted image respectively. A loss function may be evaluated in step d) by comparing the transformed synthetic contrast-weighted image with respective acquired contrast-weighted image. The first machine learning model may be adapted in step e) in accordance with the evaluated loss function. Steps a) to e) are repeated until the loss function fulfills a convergence criterion.

According to one embodiment, the transformer may be configured to perform (classic) image registration to estimate a transformation for correction of an input initial synthetic contrast-weighted image. This may enable an accurate trained module.

In another aspect the invention relates to a method for training an image generation module, the image generation module comprising a first machine learning model, the first machine learning model being configured for outputting at least one initial synthetic contrast-weighted image from at least one input magnetic resonance image, wherein the method comprises: providing at least one transformer, the transformer being configured for estimating a transformation for correction of an input initial synthetic contrast-weighted image; providing a training dataset comprising acquired contrast-weighted images of a volume and associated one or more acquired magnetic resonance images of the volume; training the image generation module using the training dataset comprising for the acquired contrast-weighted images respectively:
a) inputting at least one specific acquired magnetic resonance image which is associated with the acquired contrast-weighted images (in the training dataset) to the first machine learning model for obtaining at least one initial synthetic contrast-weighted image representing the respective acquired contrast-weighted image;
b) inputting the at least one initial synthetic contrast-weighted image and the associated acquired contrast-weighted image into the at least one transformer for estimating a transformation for aligning the initial synthetic contrast-weighted image with the associated acquired contrast-weighted image;
c) applying the estimated transformation to the at least one initial synthetic contrast-weighted image for producing at least one transformed synthetic contrast-weighted image respectively, or applying the estimated transformation to the acquired contrast-weighted images for producing respective transformed acquired contrast-weighted images;
d) evaluating a loss function by comparing the at least one transformed synthetic contrast-weighted image with the respectively acquired contrast-weighted image, or by comparing the at least one transformed acquired contrast-weighted image with the respective acquired contrast-weighted image; e) adapting the first machine learning model in accordance with the evaluated loss function; wherein steps a) to e) are repeated until the loss function fulfills a convergence criterion.

In another aspect the invention relates to a computer program comprising machine executable instructions for execution by a computational system; wherein execution of the machine executable instructions causes the computational system for: providing at least one transformer, the transformer being configured for estimating a transformation for correction of an input initial synthetic contrast-weighted image; providing a training dataset comprising acquired contrast-weighted images of a volume and associated one or more acquired magnetic resonance images of the volume; training the image generation module using the training dataset comprising for the acquired contrast-weighted images respectively:
a) inputting at least one specific acquired magnetic resonance image to the first machine learning model for obtaining at least one initial synthetic contrast-weighted image representing the acquired contrast-weighted image;
b) inputting the at least one initial synthetic contrast-weighted image and the associated acquired contrast-weighted image into the at least one transformer for estimating a transformation for aligning the initial synthetic contrast-weighted image with the associated acquired contrast-weighted image;
c) applying the estimated transformation to the at least one initial synthetic contrast-weighted image for producing at least one transformed synthetic contrast-weighted image respectively, or applying the estimated transformation to the acquired contrast-weighted image for producing a transformed acquired contrast-weighted image;
d) evaluating a loss function by comparing the transformed synthetic contrast-weighted image with the respectively acquired contrast-weighted image, or by comparing the transformed acquired contrast-weighted image with the acquired contrast-weighted image
e) adapting the first machine learning model in accordance with the evaluated loss function; wherein steps a) to e) are repeated until the loss function fulfills a convergence criterion.

It is understood that one or more of the aforementioned embodiments of the invention may be combined as long as the combined embodiments are not mutually exclusive.

As will be appreciated by one skilled in the art, aspects of the present invention may be embodied as an apparatus, method or computer program product. Accordingly, aspects of the present invention may take the form of an entirely hardware embodiment, an entirely software embodiment (including firmware, resident software, micro-code, etc.) or an embodiment combining software and hardware aspects that may all generally be referred to herein as a "circuit," "module" or "system." Furthermore, aspects of the present invention may take the form of a computer program product embodied in one or more computer readable medium(s) having computer executable code embodied thereon.

Any combination of one or more computer readable medium(s) may be utilized. The computer readable medium may be a computer readable signal medium or a computer readable storage medium. A `computer-readable storage medium' as used herein encompasses any tangible storage medium which may store instructions which are executable by a processor or computational system of a computing device. The computer-readable storage medium may be referred to as a computer-readable non-transitory storage medium. The computer-readable storage medium may also be referred to as a tangible computer readable medium. In some embodiments, a computer-readable storage medium may also be able to store data which is able to be accessed by the computational system of the computing device. Examples of computer-readable storage media include, but are not limited to: a floppy disk, a magnetic hard disk drive, a solid-state hard disk, flash memory, a USB thumb drive, Random Access Memory (RAM), Read Only Memory (ROM), an optical disk, a magneto-optical disk, and the register file of the computational system. Examples of optical disks include Compact Disks (CD) and Digital Versatile Disks (DVD), for example CD-ROM, CD-RW, CD-R, DVD-ROM, DVD-RW, or DVD-R disks. The term computer readable-storage medium also refers to various types of recording media capable of being accessed by the computer device via a network or communication link. For example, data may be retrieved over a modem, over the internet, or over a local area network. Computer executable code embodied on a computer readable medium may be transmitted using any appropriate medium, including but not limited to wireless, wire line, optical fiber cable, RF, etc., or any suitable combination of the foregoing.

A computer readable signal medium may include a propagated data signal with computer executable code embodied therein, for example, in baseband or as part of a carrier wave. Such a propagated signal may take any of a variety of forms, including, but not limited to, electro-magnetic, optical, or any suitable combination thereof. A computer readable signal medium may be any computer readable medium that is not a computer readable storage medium and that can communicate, propagate, or transport a program for use by or in connection with an instruction execution system, apparatus, or device.

`Computer memory' or 'memory' is an example of a computer-readable storage medium. Computer memory is any memory which is directly accessible to a computational system. `Computer storage' or 'storage' is a further example of a computer-readable storage medium. Computer storage is any non-volatile computer-readable storage medium. In some embodiments computer storage may also be computer memory or vice versa.

A `computational system' as used herein encompasses an electronic component which is able to execute a program or machine executable instruction or computer executable code. References to the computational system comprising the example of "a computational system" should be interpreted as possibly containing more than one computational system or processing core. The computational system may for instance be a multi-core processor. A computational system may also refer to a collection of computational systems within a single computer system or distributed amongst multiple computer systems. The term computational system should also be interpreted to possibly refer to a collection or network of computing devices each comprising a processor or computational systems. The machine executable code or instructions may be executed by multiple computational systems or processors that may be within the same computing device or which may even be distributed across multiple computing devices.

Machine executable instructions or computer executable code may comprise instructions or a program which causes a processor or other computational system to perform an aspect of the present invention. Computer executable code for carrying out operations for aspects of the present invention may be written in any combination of one or more programming languages, including an object-oriented programming language such as Java, Smalltalk, C++ or the like and conventional procedural programming languages, such as the "C" programming language or similar programming languages and compiled into machine executable instructions. In some instances, the computer executable code may be in the form of a high-level language or in a pre-compiled form and be used in conjunction with an interpreter which generates the machine executable instructions on the fly. In other instances, the machine executable instructions or computer executable code may be in the form of programming for programmable logic gate arrays.

The computer executable code may execute entirely on the user's computer, partly on the user's computer, as a stand-alone software package, partly on the user's computer and partly on a remote computer or entirely on the remote computer or server. In the latter scenario, the remote computer may be connected to the user's computer through any type of network, including a local area network (LAN) or a wide area network (WAN), or the connection may be made to an external computer (for example, through the Internet using an Internet Service Provider).

Aspects of the present invention are described with reference to flowchart illustrations and/or block diagrams of methods, apparatus (systems) and computer program products according to embodiments of the invention. It is understood that each block or a portion of the blocks of the flowchart, illustrations, and/or block diagrams, can be implemented by computer program instructions in form of computer executable code when applicable. It is further under stood that, when not mutually exclusive, combinations of blocks in different flowcharts, illustrations, and/or block diagrams may be combined. These computer program instructions may be provided to a computational system of a general-purpose computer, special purpose computer, or other programmable data processing apparatus to produce a machine, such that the instructions, which execute via the computational system of the computer or other programmable data processing apparatus, create means for implementing the functions/acts specified in the flowchart and/or block diagram block or blocks.

These machine executable instructions or computer program instructions may also be stored in a computer readable medium that can direct a computer, other programmable data processing apparatus, or other devices to function in a particular manner, such that the instructions stored in the computer readable medium produce an article of manufacture including instructions which implement the function/act specified in the flowchart and/or block diagram block or blocks.

The machine executable instructions or computer program instructions may also be loaded onto a computer, other programmable data processing apparatus, or other devices to cause a series of operational steps to be performed on the computer, other programmable apparatus or other devices to produce a computer implemented process such that the instructions which execute on the computer or other programmable apparatus provide processes for implementing the functions/acts specified in the flowchart and/or block diagram block or blocks.

A `user interface' as used herein is an interface which allows a user or operator to interact with a computer or computer system. A `user interface' may also be referred to as a `human interface device.' A user interface may provide information or data to the operator and/or receive information or data from the operator. A user interface may enable input from an operator to be received by the computer and may provide output to the user from the computer. In other words, the user interface may allow an operator to control or manipulate a computer and the interface may allow the computer to indicate the effects of the operator's control or manipulation. The display of data or information on a display or a graphical user interface is an example of providing information to an operator. The receiving of data through a keyboard, mouse, trackball, touchpad, pointing stick, graphics tablet, joystick, gamepad, webcam, headset, pedals, wired glove, remote control, and accelerometer are all examples of user interface components which enable the receiving of information or data from an operator.

A `hardware interface' as used herein encompasses an interface which enables the computational system of a computer system to interact with and/or control an external computing device and/or apparatus. A hardware interface may allow a computational system to send control signals or instructions to an external computing device and/or apparatus. A hardware interface may also enable a computational system to exchange data with an external computing device and/or apparatus. Examples of a hardware interface include, but are not limited to: a universal serial bus, IEEE 1394 port, parallel port, IEEE 1284 port, serial port, RS-232 port, IEEE-488 port, Bluetooth connection, Wireless local area network connection, TCP/IP connection, Ethernet connection, control voltage interface, MIDI interface, analog input interface, and digital input interface.

A 'display' or `display device' as used herein encompasses an output device or a user interface adapted for displaying images or data. A display may output visual, audio, and or tactile data. Examples of a display include, but are not limited to: a computer monitor, a television screen, a touch screen, tactile electronic display, Braille screen, Cathode ray tube (CRT), Storage tube, Bi-stable display, Electronic paper, Vector display, Flat panel display, Vacuum fluorescent display (VF), Light-emitting diode (LED) displays, Electroluminescent display (ELD), Plasma display panels (PDP), Liquid crystal display (LCD), Organic light-emitting diode displays (OLED), a projector, and Head-mounted display.

K-space data is defined herein as being the recorded measurements of radio frequency signals emitted by atomic spins using the antenna of a Magnetic resonance apparatus during a magnetic resonance imaging scan. Magnetic resonance data is an example of tomographic medical image data.

A Magnetic Resonance image or MR image is defined herein as being the reconstructed two- or three-dimensional visualization of anatomic data contained within the k-space data. This visualization can be performed using a computer.

### BRIEF DESCRIPTION OF THE DRAWINGS

In the following preferred embodiments of the invention will be described, by way of example only, and with reference to the drawings in which:
Fig. 1 illustrates an example of a medical system;
Fig. 2 shows a flowchart of a method for producing synthetic contrast-weighted images in accordance with an example of the present subject matter;
Fig. 3 illustrates an example of a medical system;
Fig. 4 shows a flowchart of a method for training an image generation module in accordance with an example of the present subject matter;
Fig. 5 shows a flowchart of a method for training an image generation module in accordance with an example of the present subject matter;
Fig. 6 is a diagram illustrating a method for training an image generation module in accordance with an example of the present subject matter.

### DESCRIPTION OF EMBODIMENTS

Like numbered elements in these figures are either equivalent elements or perform the same function. Elements which have been discussed previously will not necessarily be discussed in later figures if the function is equivalent.

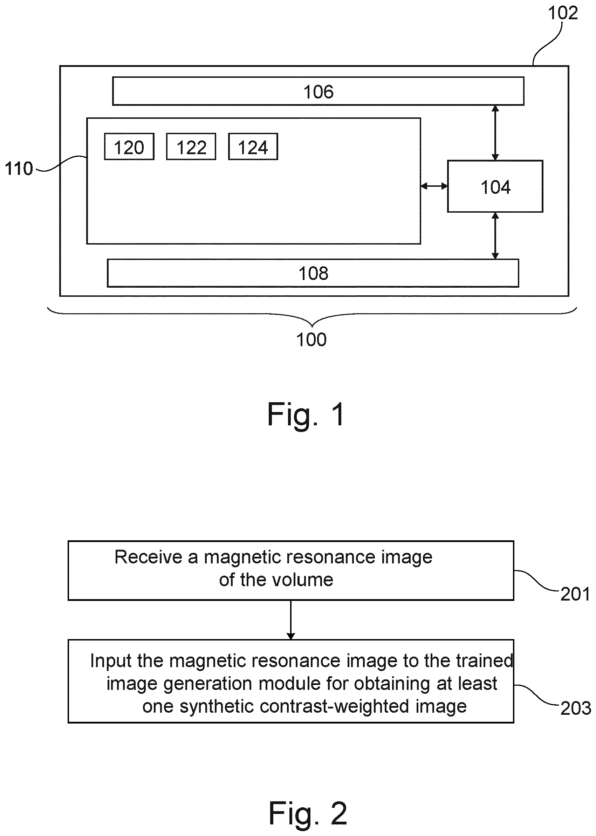

Fig. 1 illustrates an example of a medical system 100. In this example the medical system 100 comprises a computer 102 with a computational system 104. The computer 102 is intended to represent one or more computers or computer systems. The computational system 104 is intended to represent one or more computational systems or computational cores. The computer 102 is further shown as containing an optional hardware interface 106 which is connected to the computational system 104. If other components of the medical system 100 are present or included such as a magnetic resonance imaging system, then the hardware interface 106 could be used to exchange data and commands with these other components. The medical system 100 is further shown as comprising an optional user interface 108 which may provide various means for relaying data and receiving data and commands from an operator.

The medical system 100 is further shown as comprising a memory 110 that is connected to the computational system 104. The memory 110 is intended to represent various types of memory which may be accessible to the computational system 104. The memory 110 is shown as containing machine-executable instructions 120. The machine-executable instructions 120 are instructions which enable the computational system 104 to perform various control, data processing, and image processing tasks. The memory 110 is further shown as containing a trained image generation module 122 and training datasets 124 obtained from one or more web sources.

The image generation module 122 is trained to receive at least one input magnetic resonance image of a volume and output at least one synthetic contrast-weighted image based on a ground truth image representing the at least one synthetic contrast-weighted image respectively. The trained image generation module 122 is trained to compensate for a potential motion of the volume between an acquisition of the input magnetic resonance image and acquisition of the ground truth contrast-weighted image. The training may be performed using a training dataset that comprises in each entry a pair of: (*n* magnetic resonance images of the volume, *m* acquired contrast-weighted images of the volume), where n>=1 and m>=1, wherein in each iteration a pair is provided as input so that *m* synthetic contrast-weighted images may be produced from the *n* magnetic resonance images of the pair and the *m* acquired contrast-weighted images may be compared against the *m* synthetic contrast-weighted images to estimate the loss function.

In one example, image generation module 122 may comprise a machine learning model (named first machine learning model). The first machine learning model may, for example, comprise a neural network such as U-Net, a ResNet, a Vision Transformer neural network, an auto-encoder neural network, a variational auto-encoder neural network, or a convolutional neural network.

The training dataset 124 comprises acquired contrast-weighted images of a volume and associated one or more acquired magnetic resonance images of the volume.

Fig. 2 is a flowchart of a method for producing synthetic contrast-weighted images in accordance with an example of the present subject matter. For the purpose of explanation, the method described in Fig. 2 may be implemented in the system illustrated in Fig. 1, but is not limited to this implementation. The method may, for example, be performed by the medical system 100 or by another system that is configured to connect to the medical system 100. The method of Fig. 2 may describe the inference of the trained image generation module 122.

At least one magnetic resonance image of a volume may be received in step 201. In one example, the at least one input magnetic resonance image may be obtained by acquiring images at multiple saturation delays and multiple echo times (MDME). Alternatively, the at least one input magnetic resonance image may be obtained by MR Fingerprinting (MRF).

The at least one magnetic resonance image may be input in step 203 to the trained image generation module 122 for obtaining at least one synthetic contrast-weighted image. For example, if the method is performed by the system which is remotely connected to the medical system 100, the received at least one magnetic resonance image may be sent or loaded into the medical system 100 in order to input the image to the trained image generation module 122.

In one example, the present method may be used to produce a desired amount of synthetic contrast-weighted images. For that, steps 201 to 203 may be repeated multiple times in order to produce the desired amount of synthetic contrast-weighted images. Alternatively, further magnetic resonance images may be received in step 201 and step 203 may be performed for each image of the received images in order to produce the desired amount of synthetic contrast-weighted images.

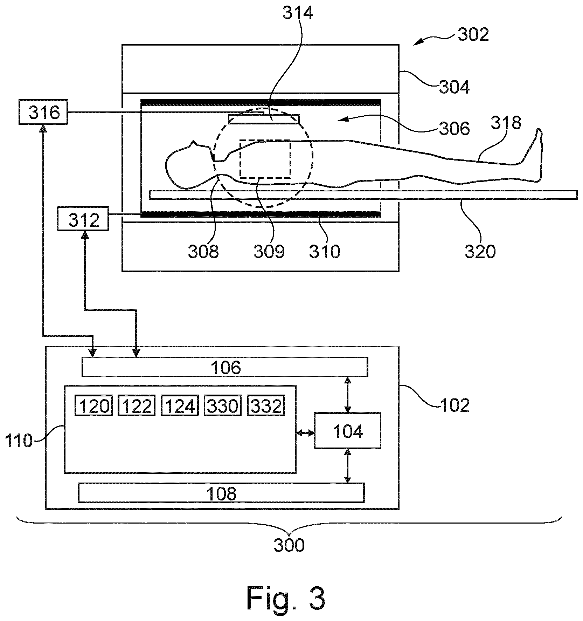

Fig. 3 illustrates a further example of the medical system 300. The medical system in Fig. 3 is similar to that as in Fig. 1 except that it additionally comprises a magnetic resonance imaging system 302 that is controlled by the computational system 104. The example illustrated in Fig. 3 is a magnetic resonance imaging system 302.

The magnetic resonance imaging system 302 comprises a magnet 304. The magnet 304 is a superconducting cylindrical type magnet with a bore 306 through it. The use of different types of magnets is also possible; for instance it is also possible to use both a split cylindrical magnet and a so called open magnet. A split cylindrical magnet is similar to a standard cylindrical magnet, except that the cryostat has been split into two sections to allow access to the iso-plane of the magnet, such magnets may for instance be used in conjunction with charged particle beam therapy. An open magnet has two magnet sections, one above the other with a space in-between that is large enough to receive a subject: the arrangement of the two sections area similar to that of a Helmholtz coil. Open magnets are popular, because the subject is less confined. Inside the cryostat of the cylindrical magnet there is a collection of superconducting coils.

Within the bore 306 of the cylindrical magnet 304 there is an imaging zone 308 where the magnetic field is strong and uniform enough to perform magnetic resonance imaging. A field of view 309 is shown within the imaging zone 308. The k-space data that is acquired typically acquired for the field of view 309. The region of interest could be identical with the field of view 309 or it could be a sub volume of the field of view 309. A subject 318 is shown as being supported by a subject support 320 such that at least a portion of the subject 318 is within the imaging zone 308 and the field of view 309.

Within the bore 306 of the magnet there is also a set of magnetic field gradient coils 310 which is used for acquisition of preliminary k-space data to spatially encode magnetic spins within the imaging zone 308 of the magnet 304. The magnetic field gradient coils 310 connected to a magnetic field gradient coil power supply 312. The magnetic field gradient coils 310 are intended to be representative. Typically, magnetic field gradient coils 310 contain three separate sets of coils for spatially encoding in three orthogonal spatial directions. A magnetic field gradient power supply supplies current to the magnetic field gradient coils. The current supplied to the magnetic field gradient coils 310 is controlled as a function of time and may be ramped or pulsed.

Adjacent to the imaging zone 308 is a radio-frequency coil 314 for manipulating the orientations of magnetic spins within the imaging zone 308 and for receiving radio transmissions from spins also within the imaging zone 308. The radio frequency antenna may contain multiple coil elements. The radio frequency antenna may also be referred to as a channel or antenna. The radio-frequency coil 314 is connected to a radio frequency transceiver 316. The radio-frequency coil 314 and radio frequency transceiver 316 may be replaced by separate transmit and receive coils and a separate transmitter and receiver. It is understood that the radio-frequency coil 314 and the radio frequency transceiver 316 are representative. The radio-frequency coil 314 is intended to also represent a dedicated transmit antenna and a dedicated receive antenna. Likewise, the transceiver 316 may also represent a separate transmitter and receivers. The radio-frequency coil 314 may also have multiple receive/transmit elements and the radio frequency transceiver 316 may have multiple receive/transmit channels.

The transceiver 316 and the gradient controller 312 are shown as being connected to the hardware interface 106 of the computer system 102.

The memory 110 is further shown as containing pulse sequence commands 330. The pulse sequence commands 330 are commands or data which can be converted into commands which enable the computational system 104 to control the magnetic resonance imaging system to acquire k-space data 332. The memory 110 shows the k-space data 332 that has been acquired by controlling the magnetic resonance imaging system with the pulse sequence commands 330. The magnetic resonance images reconstructed from the k-space data 332 may, for example, be used in accordance with an example of the present subject matter.

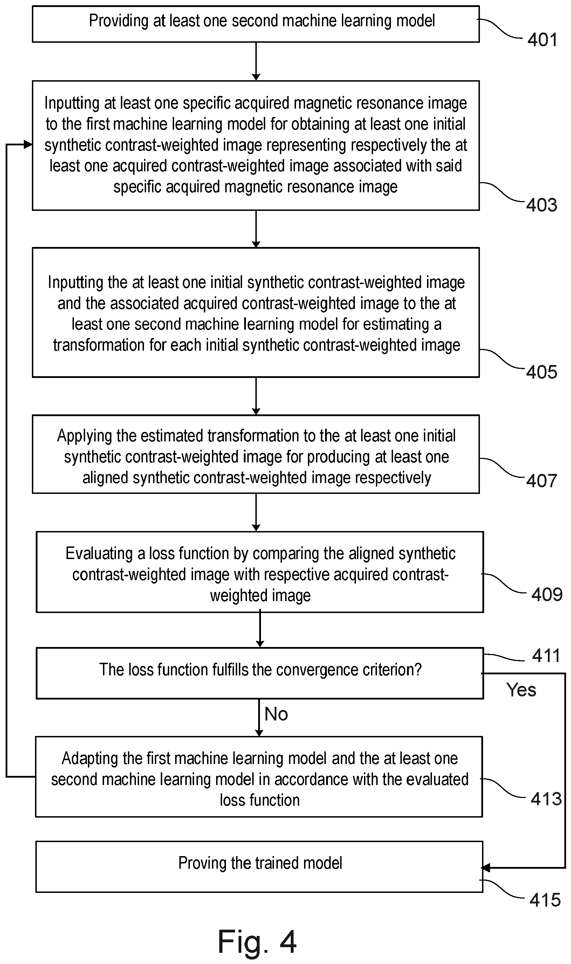

Fig. 4 is a flowchart of a method for training the image generation module 122 using the training dataset 124 in accordance with an example of the present subject matter. For the purpose of explanation, the method described in Fig. 4 may be implemented in the system illustrated in Fig. 1, but is not limited to this implementation. The method may, for example, be performed by the user medical system 100.

At least one second machine learning model may be provided in step 401. The at least one second machine learning model may, for example, be received in step 401. Each second machine learning model represents a respective contrast type. Each second machine learning model is configured for estimating a transformation for correction of an input initial synthetic contrast-weighted image using a real contrast-weighted image which is acquired in accordance with the contrast type of the second machine learning model.

At least one specific acquired magnetic resonance image of the training dataset 124 may be input in step 403 to the first machine learning model for obtaining at least one initial synthetic contrast-weighted image representing respectively the at least one acquired contrast-weighted image associated with said specific acquired magnetic resonance image. In one example, the at least one input magnetic resonance image may be obtained by acquiring images at multiple saturation delays and multiple echo times (MDME). Alternatively, the at least one input magnetic resonance image may be obtained by MR Fingerprinting (MRF).

The at least one initial synthetic contrast-weighted image and the associated acquired contrast-weighted image may be input in step 405 to the at least one second machine learning model for estimating a transformation for each initial synthetic contrast-weighted image.

The at least one estimated transformation may be applied in step 407 to the at least one initial synthetic contrast-weighted image for producing at least one aligned synthetic contrast-weighted image respectively.

A loss function may be evaluated in step 409 by comparing the transformed synthetic contrast-weighted image with respective acquired contrast-weighted image.

It may be determined in step 411 whether the loss function fulfills a convergence criterion. If the convergence criterion is not fulfilled, the first machine learning model and the at least one second machine learning model may be adapted in step 413 in accordance with the evaluated loss function and steps 403 to 411 are repeated. If the convergence criterion is fulfilled the resulting trained first machine learning model may be provided in step 415.

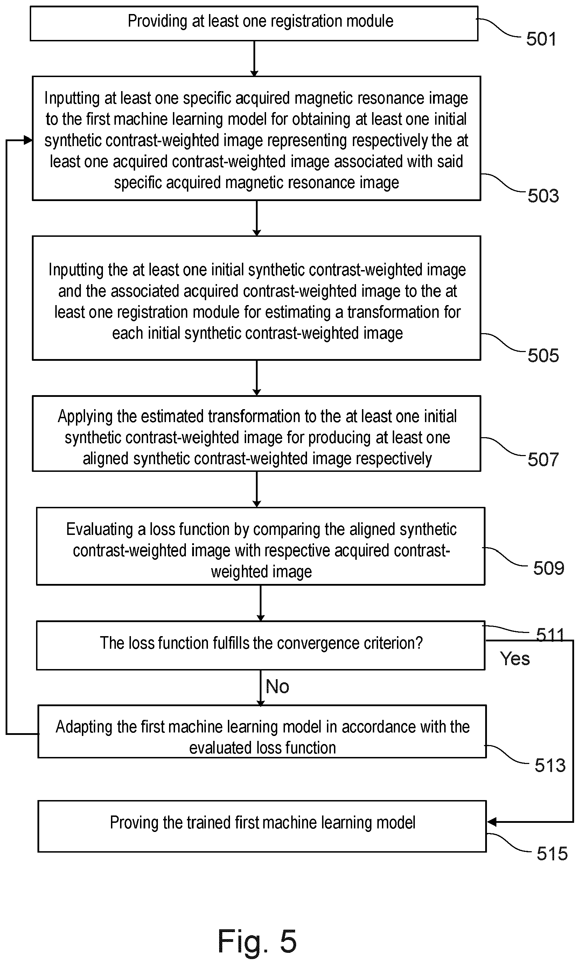

Fig. 5 is a flowchart of a method for training the image generation module 122 using the training dataset 124 in accordance with an example of the present subject matter. For the purpose of explanation, the method described in Fig. 5 may be implemented in the system illustrated in Fig. 1, but is not limited to this implementation. The method may, for example, be performed by the medical system 100.

At least one registration module may be provided in step 501. Each registration module represents a respective contrast type. Each registration module is configured for performing image registration in order to estimate a transformation for correction of an input initial synthetic contrast-weighted image using a real contrast-weighted image which is acquired in accordance with the contrast type of the second machine learning model.

At least one specific acquired magnetic resonance image of the training dataset 124 may be input in step 503 to the first machine learning model for obtaining at least one initial synthetic contrast-weighted image representing respectively the at least one acquired contrast-weighted image associated with said specific acquired magnetic resonance image.

The at least one initial synthetic contrast-weighted image and the associated acquired contrast-weighted image may be input in step 505 to the at least one registration module for estimating a transformation for each initial synthetic contrast-weighted image.

The at least one estimated transformation may be applied in step 507 to the at least one initial synthetic contrast-weighted image for producing at least one aligned synthetic contrast-weighted image respectively.

A loss function may be evaluated in step 509 by comparing the transformed synthetic contrast-weighted image with respective acquired contrast-weighted image.

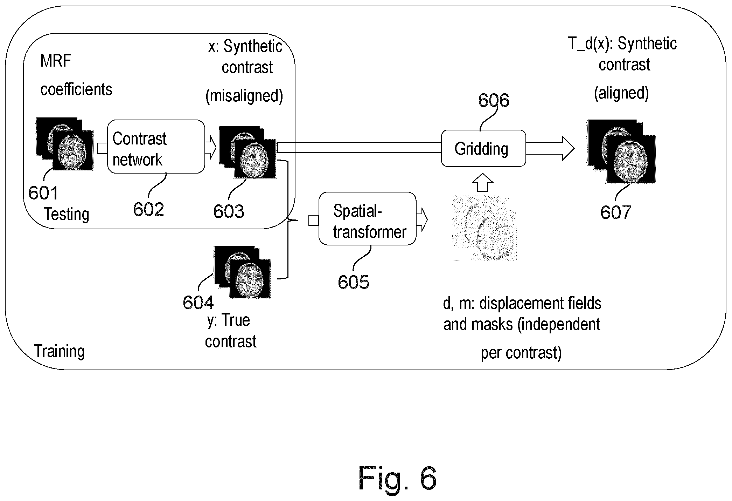

It may be determined in step 511 whether the loss function fulfills a convergence criterion. If the convergence criterion is not fulfilled, the first machine learning model may be adapted in step 513 in accordance with the evaluated loss function and steps 503 to 511 are repeated. If the convergence criterion is fulfilled the resulting trained first machine learning model may be provided in step 515. Fig. 6 is a diagram illustrating a method of training an image generation module in accordance with an example, of the present subject matter.

A suitable neural network 602 for contrast generation may be chosen. The contrast network 602 may map a set of input images 601 to one or more target images 604. The contrast network 602 may be configured to generate for each input image 601 one or more synthetic contrast-weighted images 603, wherein the one or more synthetic contrast-weighted images 603 are associated with respective real/target contrast-weighted images 604. Each target contrast-weighted image may represent a contrast type.

One or more alignment modules 605 may be inserted before computing the loss of the estimated output 603 with the target contrast-weighted images 604. The alignment module 605 may, for example, comprise a neural network. There can be one alignment module for all contrasts, or a separate alignment module for each target contrast image.

The alignment module 605 is trained together with the contrast generation network 602 and successively learns to estimate good transformations to better align estimated output 603 and target images 604. The transformations may, for example, be provided as displacement fields. The transformations may be applied (606) to the generated synthetic contrast-weighted image 603 in order to produce corrected (e.g., aligned) synthetic contrast-weighted image 607. The loss function may be estimated using the corrected synthetic contrast-weighted image 607 and the associated real contrast-weighted image 604.

Before training., the alignment network 605 may, for example, be initialized to the identity transformation. Optionally, the training of the alignment module 605 may be skipped until the contrast generation network 602 has sufficiently stabilized. This may facilitate the task of the alignment network(s) 605 which then only have to learn a spatial transform between images of very similar contrast. The training process is driven by the original loss function for training the contrast generation network 602, and not explicit alignment loss may be needed.

In one example, in addition to the spatial transformation, a mask or weighting may be learned that determines whether the spatial transformation can successfully align the images. This can be useful to reduce the weight of positions where the alignment cannot be improved. A possible situation would be for through-plane motion between stacks of 2D images.

The above mask/weight may be used in various ways to guide the loss function. For example, by shifting the weight between aligned and unaligned situations. Or just using the weighted aligned loss.

In one example, instead of the deformable transformation depicted in Figure 6, rigid or affine transformations could be used. The deformation field can be regularized to enforce smoothness, or computed at lower resolution for restricting its expressive power. An alternative could also be patch-wise application of rigid or affine transforms.

In one alternative example, instead of applying the alignment module 605 at the output 603, the alignment module 605 may also be applied to the input images 601 before being passed into the contrast network 602. This may be beneficial in the case that the input data can be reformatted separately for each target image.

In another example, multiple input images are used to estimate one or more synthetic images. The alignment network 605 can be applied to the input images at inference to assure that the synthetic images are of high quality.

## Claims

1. A medical system for producing synthetic contrast-weighted images, the medical system comprising: a memory storing machine executable instructions; and a computational system, wherein execution of the machine executable instructions causes the computational system to:
provide a trained image generation module, the trained image generation module being configured to generate from at least one input magnetic resonance image of a volume at least one synthetic contrast-weighted image of the volume, the image generation module being trained by compensating for acquisition artefacts in training input magnetic resonance images and associated training acquired contrast-weighted images;
receive at least one magnetic resonance image of the volume;
input the at least one magnetic resonance image into the trained image generation module for obtaining the at least one synthetic contrast-weighted image.

2. The medical system of any of the preceding claims, wherein the acquisition artefacts are misalignments which are caused by a motion of the volume between an acquisition of the training input magnetic resonance image and acquisition of the associated training acquired contrast-weighted image.

3. The medical system of any of the preceding claims, the synthetic contrast-weighted image being of a specific contrast type, wherein contrast type comprises any one of the following: a T1 weighted contrast, a T2 weighted contrast, a fluid attenuated inversion recovery (FLAIR) contrast, a double inversion recovery (DIR) contrast, a T2-star weighted contrast, a Dixon water contrast, a Dixon fat contrast, a Dixon fat fraction contrast, a diffusion weighted contrast, a functional magnetic resonance contrast, a proton density magnetic resonance contrast, and combinations thereof.

4. The medical system of any of the preceding claims, wherein the medical system further comprises a magnetic resonance imaging system, wherein the memory further contains pulse sequence commands configured to control the magnetic resonance imaging system to acquire k-space data according to the magnetic resonance imaging protocol, wherein execution of the machine executable instructions further causes the computational system to: acquire the k-space data by controlling the magnetic resonance imaging system; reconstruct the magnetic resonance image from the k-space data.

5. The medical system of any of the preceding claims, the medical system comprising the trained image generation module or being configured to connect to a remote system comprising the trained image generation module.

6. A method for training an image generation module, the image generation module comprising a first machine learning model, the first machine learning model being configured for outputting at least one initial synthetic contrast-weighted image from at least one input magnetic resonance image, wherein the method comprises:
providing at least one transformer, the transformer being configured for estimating a transformation for correction of an input initial synthetic contrast-weighted image;
providing a training dataset comprising entries, the entry comprising one or more acquired contrast-weighted images of a volume and associated one or more acquired magnetic resonance images of the volume;
training the image generation module using the training dataset comprising for the acquired contrast-weighted images respectively:
a) inputting at least one specific acquired magnetic resonance image associated with the acquired contrast-weighted images to the first machine learning model for obtaining at least one initial synthetic contrast-weighted image representing the respective acquired contrast-weighted image;
b) inputting the at least one initial synthetic contrast-weighted image and the associated acquired contrast-weighted image into the at least one transformer for estimating a transformation for aligning the initial synthetic contrast-weighted image with the associated acquired contrast-weighted image;
c) applying the estimated transformation to the at least one initial synthetic contrast-weighted image for producing at least one transformed synthetic contrast-weighted image respectively;
d) evaluating a loss function by comparing the at least one transformed synthetic contrast-weighted image with the respectively acquired contrast-weighted image;
e) in case the loss function does not fulfill a convergence criterion,
adapting the first machine learning model in accordance with the evaluated loss function, and repeating steps a) to e); otherwise, providing the trained first machine learning model.

7. The method of claim 6, wherein the at least one transformer comprises at least one second machine learning model respectively, wherein the adapting step e) further comprises adapting the at least one second machine learning model.

8. The method of claim 7, further comprising weighting the loss function with a trainable weight of the second machine learning model, the weight indicating a level of success of the transformation to perform the alignment of the images.

9. The method of any of the preceding claims 7 to 8, the at least one synthetic contrast-weighted image being multiple synthetic contrast-weighted images representing different contrast types respectively, wherein the at least one second machine learning model is one machine learning model.

10. The method of any of the preceding claims 7 to 8, the at least one synthetic contrast-weighted image being multiple synthetic contrast-weighted images representing different contrast types respectively, wherein the at least one second machine learning model comprises one second machine learning model per contrast type.

11. The method of any of the preceding claims 7 to 10, the first machine learning model being a neural network, the second machine learning model being a neural network.

12. The method of any of the preceding claims 6 to 11, wherein before executing the training method, the method further comprises pre-training the first machine learning model with another training dataset comprising acquired contrast-weighted images of a volume and associated one or more acquired magnetic resonance images of the volume.

13. The method of any of the preceding claims 6 to 12, further comprising: receiving a magnetic resonance image of the volume; inputting the magnetic resonance image to the trained image generation module for obtaining the at least one synthetic contrast-weighted image.

14. The method of any of the preceding claims 6 or 13, the at least one transformer being configured to perform a registration for estimating the transformation.

15. A computer program comprising machine executable instructions, wherein execution of the machine executable instructions causes a computational system to perform the training method of claim 6.
